(19) **Europäisches Patentamt**

**European Patent Office**

**Office européen des brevets**

(11) **EP 0 432 900 B1**

(12) # EUROPEAN PATENT SPECIFICATION

(45) Date of publication and mention
of the grant of the patent:
**24.04.1996 Bulletin 1996/17**

(51) Int Cl.$^6$: **H01L 27/11**, H01L 27/02,
H01L 21/82

(21) Application number: **90312363.6**

(22) Date of filing: **13.11.1990**

(54) **Method of producing a semiconductor memory device using a phase shifting mask**

Verfahren zur Herstellung einer Halbleiterspeicherstruktur unter Verwendung einer phasenverschiebenden Maske

Procédé de fabrication des structures de mémoire semi-conductrice avec masques à décalage de phase associés

(84) Designated Contracting States:
**DE FR GB**

(30) Priority: **15.11.1989 JP 296775/89**

(43) Date of publication of application:
**19.06.1991 Bulletin 1991/25**

(73) Proprietor: **SONY CORPORATION**
**Tokyo 141 (JP)**

(72) Inventors:
- **Konishi, Morikazu, c/o Patents Division**
  **Shinagawa-ku Tokyo 141 (JP)**
- **Shimizu, Hideo, c/o Patents Division**
  **Shinagawa-ku Tokyo 141 (JP)**

(74) Representative: **Cotter, Ivan John et al**
**D. YOUNG & CO.**
**21 New Fetter Lane**
**London EC4A 1DA (GB)**

(56) References cited:
**EP-A- 0 281 711**          **EP-A- 0 281 711**
**GB-A- 2 065 971**

- **IEEE TRANSACTIONS ON ELECTRON DEVICES, vol. ED-29, no. 12, December 1982, pages 1828-1836, New York, US; M.D. LEVENSON et al.: "Improving resolution in photolithography with a phase-shifting mask"**
- **Electronics Engineers' Handbook, eds. Fink and Christiansen, 1989, McGraw-Hill Book Co., pp. 8-99 to 8-100.**

## Description

This invention relates to a method of making semiconductor memory structures using phase shifting masks. The invention can be applied, for example, to CMOS memory cells.

The dimensions of semiconductor devices tend to get smaller and smaller year by year.

In the technology of photolithography employed for the manufacture of miniaturized semiconductor devices, there is known, as a means for improving the resolution, a phase shifting technique which causes a phase difference in the light wave transmitted through a mask. This phase shifting method is disclosed in Japanese laid-open patent specification 58/173744; and also in Marc D. Levenson et al., "Improving Resolution in Photolithography with a Phase-Shifting Mask, IEEE transactions on Electron Devices, Vol. ED-29, No. 12, December 1982, pages 1828 to 1836.

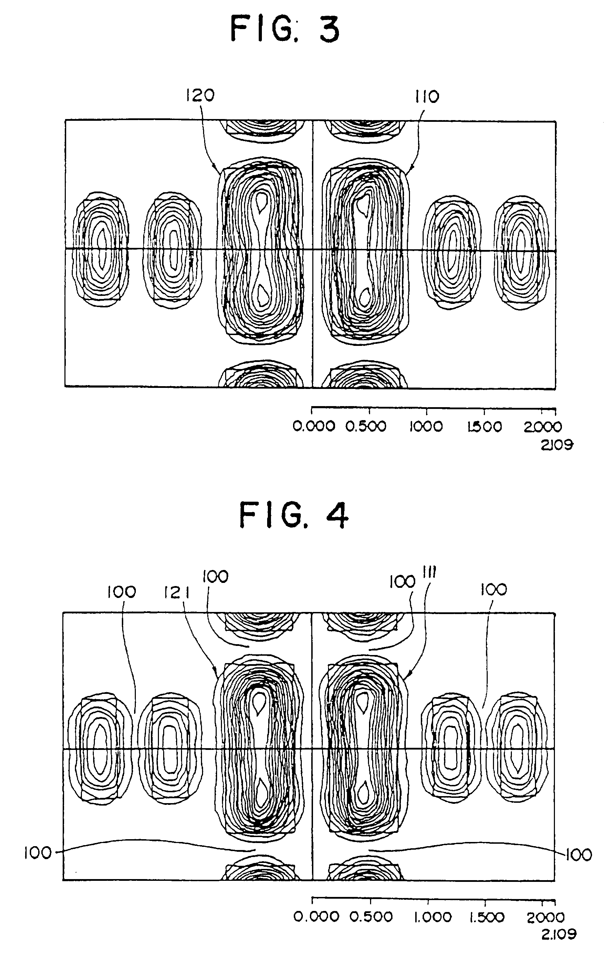

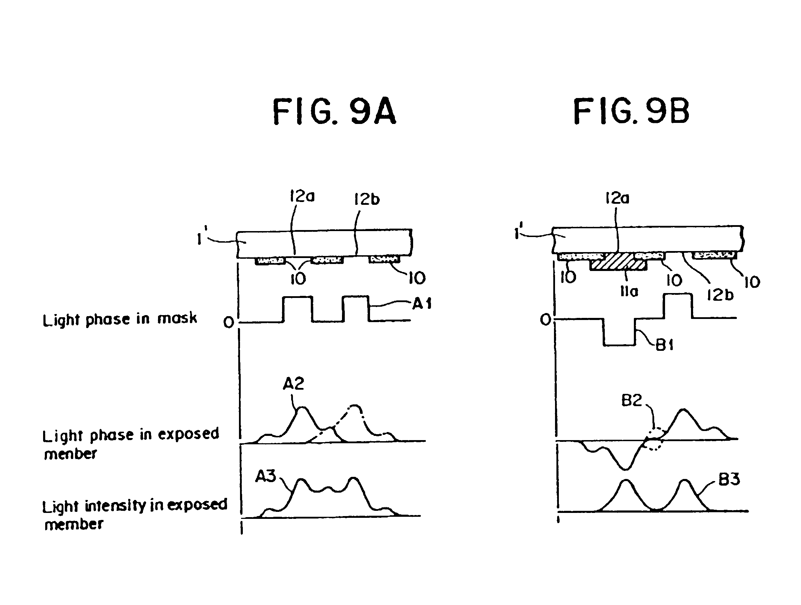

The known phase shifting method will now be described with reference to Figure 9. In the case of forming a line-and-space pattern, it is usual that, as shown in Figure 9A, a light shielding region 10 is formed by the use of a light shielding material such as chromium on a transparent substrate 1 of quartz or the like, and an arrangement of repeated line-and-space patterns is formed to produce an exposure mask. The intensity distribution of the light transmitted through such an exposure mask is represented by a curve A1 in Figure 9A, wherein the intensity is zero in the light shielding region 10, while the light is transmitted through the other portions (light transmitting portions 12a and 12b). Viewing one light transmitting portion 12a as an example, the intensity of the light transmitted therethrough and irradiated on a work member to be exposed is distributed as represented by a curve A2 in Figure 9A, wherein hill-like maxima exist on both sides due to diffraction of the light and so forth. The light passed through the light transmitting portion 12b is represented by a one-dot chain line. When the light rays obtained through the individual light transmitting portions 12a and 12b are mutually combined, the light intensity distribution is deprived of its sharpness as indicated by a curve A3, consequently to blur the image due to diffraction of the light. In contrast therewith, if phase shifting film portions 11a are provided on the light transmitting portions 12a and 12b of the repeated patterns alternately as shown in Figure 9B, any blur of the image resulting from diffraction of the light is eliminated by inversion of the phase, so achieving transfer of a sharp image, thereby improving the resolution and the focusing tolerance. More particularly, when the phase shifting film 11a is formed on the light transmitting portion 12a as shown in Figure 9B in such a manner as to cause a phase shift of 180° for example, the light passed through the phase shifting film 11a is inverted as represented by a curve B1. Meanwhile the light obtained through the adjacent light transmitting portion 12b is not passed through the phase shifting film 11a, so that no such phase inversion occurs. Therefore, on the work member to be exposed, the mutually phase-inverted light rays cancel each other in the position B2 at the feet of the light intensity distribution, whereby the distribution of the light irradiated on the work member is rendered ideally sharp as represented by a curve B3 in Figure 3B.

In the example mentioned, the greatest advantage is attainable by causing a 180° inversion of the phase to ensure the above-described effect. However, for realizing such a satisfactory result, it is necessary for the phase shifting film 11a to have an adequate thickness

$$d = \frac{\lambda}{2(n-1)}$$

(where n denotes the refractive index of the phase shifting film, and λ denotes the wavelength of the exposure light).

In the process of forming a pattern by exposure, it is customary that a member used for reduced-size projection is termed a reticle, and a member for life-size projection is termed a mask; or a member corresponding to an original sheet is termed a reticle, and a member obtained by duplicating such a reticle is termed a mask. In this specification, any of the masks and reticles classified by such various definitions are included in the term mask.

However, in the known phase shifting exposure mask, there are some difficulties in using it for forming a complicated pattern, although it is effective for forming a relatively simple pattern with a line-and-space or contact hole arrangement for example.

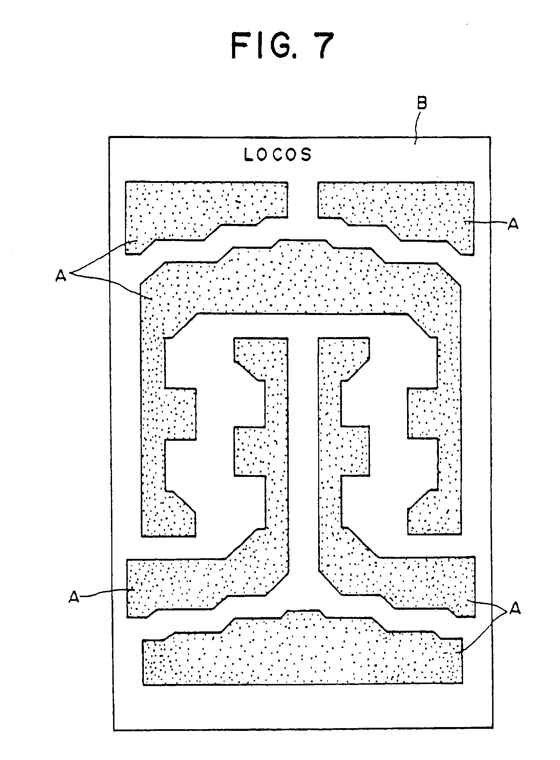

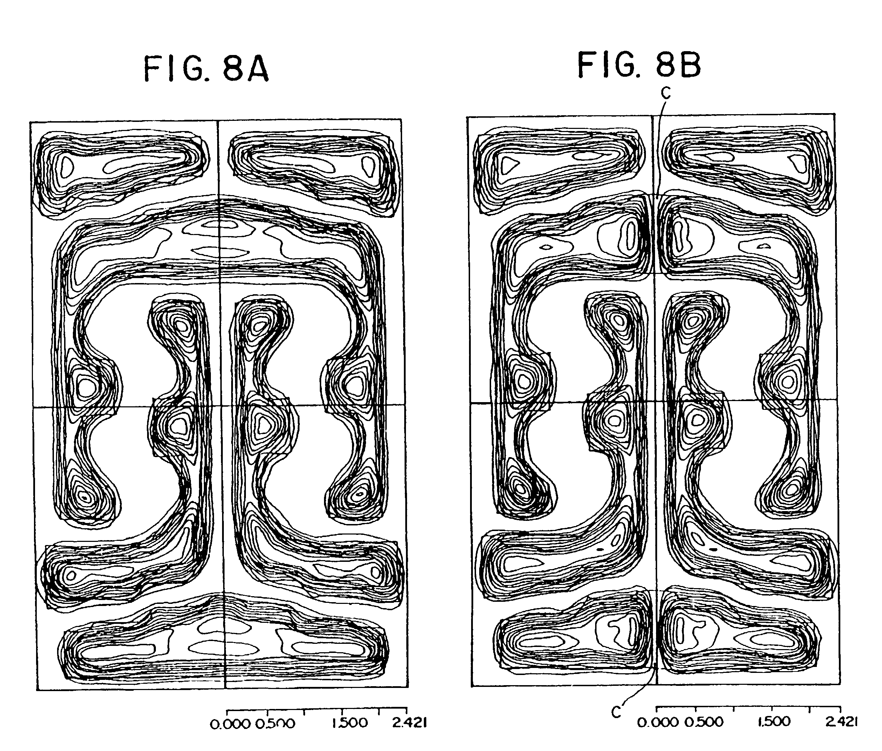

The pattern of a semiconductor memory device such as a CMOS memory cell is generally complicated, as shown in Figure 7. In this diagram, A denotes a diffused layer portion, and B denotes a LOCOS portion. As the design becomes finer from say 0.5 μm down to 0.3 to 0.35 μm, accurate patterning in a general exposure mask is rendered more difficult, and employment of the phase shifting method is considered necessary. However, in such a complicated pattern as shown in Figure 7, for example, the desired effect is barely attainable by the phase shifting technique. In a case where the minimum line width of the pattern in Figure 7 is 0.3 μm and the light intensity distribution is calculated with an exposure to the light emitted from a KrF excimer laser, there is hardly any observable difference between the result obtained without (Figure 8A) or with (Figure 8B) the phase shifting technique. In either case, the pattern deviates considerably from the required one. Denoted by C in Figure 8B is a pattern to be formed continuously. In this drawing, the pattern is divided into two parts due to the necessity of causing a phase inversion, and therefore the light intensity distribution becomes as illustrated.

The above-cited Levenson et al reference discloses the use of a phase shifting mask for producing a semiconductor device, the mask comprising a light shielding region. light transmitting portions and phase shifting film portions on a substrate transparent to the wavelength of coherent exposure light, said light transmitting portions and phase shifting film portions being arranged alternately in pairs each pair consisting of one light transmitting portion and one phase shifting film portion and including mutually adjacent parallel portions. and the spacings of the mutually adjacent parallel portions of said pairs and the thicknesses of said film portions being such as to promote destructive interference of the exposure light.

The present invention provides a method of producing a semiconductor device using a phase shifting mask, the mask comprising a light shielding region, light transmitting portions and phase shifting film portions on a substrate transparent to the wavelength of coherent exposure light, said light transmitting portions and phase shifting film portions being arranged alternately in pairs, each pair consisting of one light transmitting portion and one phase shifting film portion and including mutually adjacent parallel portions, and the spacings of the mutually adjacent parallel portions of said pairs and the thicknesses of said film portions being such as to promote destructive interference of the exposure light, characterised in that:

the semiconductor device is a semiconductor memory structure having a plurality of cells each comprising a four transistor circuit formed of elemental patterns;
said mutually adjacent parallel portions of said pairs are arranged such that the mutually adjacent parallel portions of three adjacent pairs of said elemental patterns corresponding thereto are positioned parallel with one another and such that the mutually adjacent parallel portions of the elemental patterns of the central one of said three pairs are within one of said cells and the mutually adjacent parallel portions of the elemental patterns of each of the other two of said three pairs are arranged so that one is within said one cell and the other is in a respective cell adjacent to said one cell; and
the four said mutually adjacent parallel portions of said three adjacent pairs of elemental patterns that are within said one cell are interconnected to form said four transistor circuit.

As described hereinbelow, such a technique can enable the achievement of an improvement in the complicated elemental patterns of a memory structure, in particular a CMOS memory structure, so that fine patterns can be formed.

The invention will now be described by way of example with reference to the accompanying drawings, throughout which like parts are referred to by like references, and in which:

Figure 1 is view of a phase shifting mask used for a first embodiment of the invention;
Figures 2A and 2B illustrate the phase shifting mask in more detail;
Figure 3 shows the light intensity distribution obtained by the phase shifting mask of Figure 1;
Figure 4 shows the light intensity distribution obtained by a known mask;
Figures 5A and 5B show the first embodiment of semiconductor memory structure;
Figures 6A and 6B show a second embodiment of semiconductor memory structure;
Figure 7 is a view of a known memory cell pattern;
Figure 8A and 8B show the intensity distributions of exposure light in formong the pattern of Figure 7; and
Figures 9A and 9B illustrate the principle of a phase shifting mask.

A semiconductor memory structure comprises a pattern layer having a plurality of elemental patterns, and another pattern layer having, in a single cell or adjacent cells, more than one pair of elemental patterns including mutually proximate parallel portions.

In this specification, an "elemental pattern" connotes any of various patterns required for forming a semiconductor memory structure, such as a diffused layer pattern, an element isolating region, or a wiring pattern.

A "cell" is a general term including at least one semiconductor device which constitutes a memory. In this specification, the concept of a cell connotes one unit having a plurality of elemental patterns. And a pattern layer signifies a layer which comprises such elemental patterns and is existent over two or more cells.

Also in this specification, the requisite of "elemental patterns including mutually proximate parallel portions" is that the elemental patterns themselves are mutually proximate and parallel to each other in the longitudinal direction thereof or at least have mutually proximate and parallel portions such as one side of each pattern. Another requisite is satisfied if at least one pair of elemental patterns having such interrelation exist in the pattern layer. Meanwhile, "proximate" signifies a positional adjacency adequate for attaining at least the effect of the phase shift. For this purpose, it is generally desired that the proximity or adjacency be such as corresponding to the wavelength of exposure light employed.

A phase shifting mask is provided for use in producing a semiconductor memory device and has a light shielding region, light transmitting segments and phase shifting films on a substrate transparent to the wavelength of exposure light, wherein the light transmitting segments and the phase shifting films constitute pairs each including mutually proximate parallel portions.

In this specification, "transparent to the wavelength of exposure light" signifies "capable of passing or transmitting the wavelength of employed exposure light therethrough". The phase shifting film serves to cause a desired shift in the phase of the transmitted light. Generally such a film is composed of a material transparent to the exposure light wavelength and has a thickness adequate for inducing a desired phase shift. The material and the thickness of the film may be so determined selectively as to attain a phase inversion of 180° or any desired amount of phase shift such as 90° or 270° in conformity with each design. For example, in a preferred embodiment of this invention, the film thickness d is given by:

$$d = \frac{\lambda}{2(n-1)}$$

for achieving a phase shift of 180°. In the above equation, n denotes the refractive index of the phase shifting film and is therefore determined by the material of the film, and $\lambda$ denotes the exposure wavelength which is determined by the exposure light employed.

The light shielding region may be composed of any suitable material such as chromium which is capable of absorbing and thereby shielding the exposure light employed.

First Embodiment

This embodiment corresponds to a semiconductor memory device, more specifically to a CMOS memory device obtained by using a phase shifting mask.

First a description will be given of the phase shifting mask used in this embodiment.

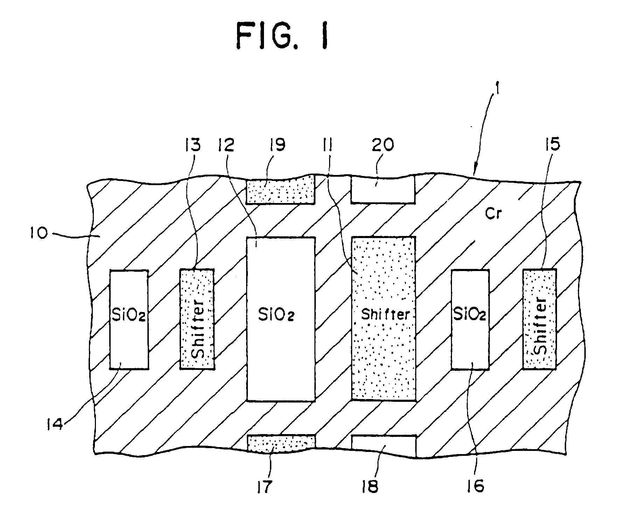

The phase shifting mask shown in Figure 1 is used for forming a diffused layer in the semiconductor memory structure of this embodiment. As illustrated, the phase shifting mask comprises a light shielding region 10, light transmitting portions 12, 14, 16, 18 and 20, and phase shifting films 11, 13, 15, 17 and 19 formed on a substrate 1 transparent to the wavelength of exposure light, wherein the light transmitting portions and the phase shifting films form more than one pair having mutually proximate parallel portions. Denoted in Figure 1 by 11, 12; 13, 14; 15, 16; 17, 18; and 19, 20 are pairs each consisting of one light transmitting portion and one phase shifting film. More specifically, the pairs are arranged to have such a positional relationship that, as illustrated, the rectangular light transmitting portions and the rectangular phase shifting films are disposed parallel with each other in the longitudinal direction.

In this embodiment, the substrate 1 is composed of silicon dioxide (SiO$_2$) or quartz, and the light shielding region 10 is obtained by evaporation of chromium in the shape of a film on the substrate 1. The light transmitting portions 12, 14, 16, 18 and 20 are so formed as to expose the substrate material directly for permitting transmission of the exposure light therethrough. The light transmitting portions 12, 14, 16, 18 and 20 are patterned in such a manner that none of the light shielding region 10 is existent thereat. The phase shifting films 11, 13, 15, 17 and 19 are so formed as to cause a 180° phase inversion of the exposure light. In this embodiment, such film is composed of silicon dioxide to have a thickness of 500 nm. Some other suitable material may alternatively be selected on condition that it retains a phase shifting effect, and a resist material may also be used to form each phase shifting film.

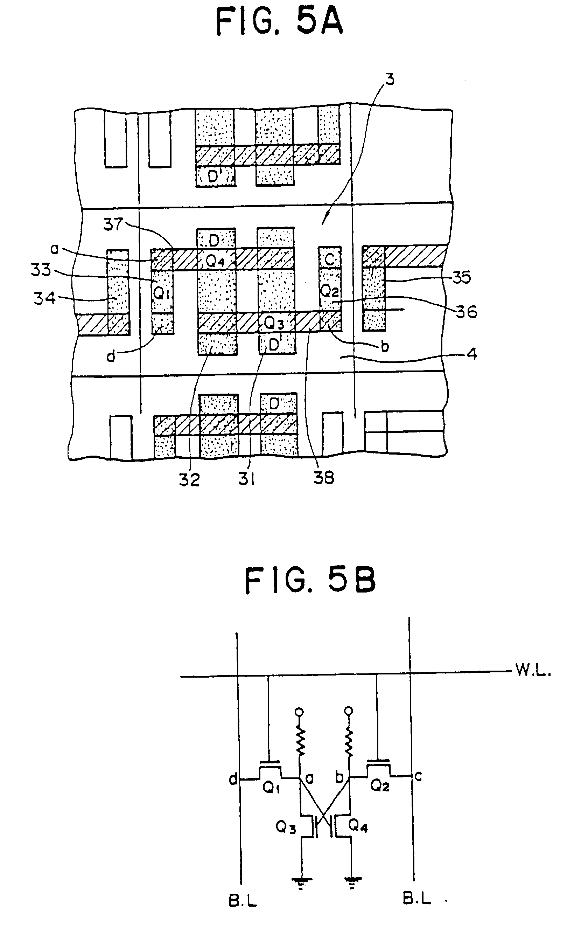

The semiconductor memory structure of this embodiment is shown in Figure 5A, wherein elemental patterns 31 to 36 exist in a single pattern layer. The pattern layer has, in one cell or mutually adjacent cells (reference numeral 3 denotes a cell unit), more than one pair of elemental patterns each having mutually proximate parallel portions. In the structure of this embodiment, the patterns 31 and 32 of diffused layers form a pair having mutually proximate parallel portions. Similarly the patterns 33 and 34, and the patterns 35 and 36 constitute such a pair, respectively. Each pattern is composed of a diffused layer to fabricate a transistor structure. Denoted by 37 and 38 in Figure 5A are gate electrode patterns which are in another pattern layer different from that of the elemental patterns 31 to 36. Figure 5B is a circuit diagram representing the structure of Figure 5A. Denoted by Q1 to Q4 and a to d are a transistor structure and a connection structure respectively, which show the relationship of mutual correspondence between the configurations of Figures 5a and 5B. In Figure 5B, W.L. stands for a word line, and B.L. for a bit line.

In this embodiment, the diffused layers of the patterns 31 and 32 form a driver transistor and are therefore shaped to be greater than the other diffused layer patterns 33 to 36 as illustrated in Figure 5A.

The semiconductor memory structure of Figure 5A corresponds to the phase shifting mask of Figure 1, and the phase shifting film 11 and the light transmitting portion 12 in the phase shifting mask correspond respectively to the diffused layer patterns 31 and 32 of the semiconductor memory structure. Furthermore, the pair 13 and 14 and the pair 15 and 16 in Figure 1 correspond respectively to the pair of patterns 33 and 34 and the pair of patterns 35 and 36 in Figure 5A.

Patterns existing in one pattern layer in the structure of Figure 5A can be formed in a satisfactory state by the phase shifting mask of Figure 1, as will be ensured also from the following. Figure 3 shows the calculated light intensity distribution when the patterns of Figure 5A are formed by using the phase shifting mask of Figure 1 under the conditions including a minimum line width of 0.3 μm and the employment of a KrF excimer laser. In contrast therewith, Figure 4 shows the result of calculating the light intensity distribution when similar patterns are formed under the same conditions as the above by using a known mask without the phase shifting process. It is apparent from a comparison of these two results that an enhanced pattern accuracy can be attained by using the mask of this embodiment.

Particularly in the use of the known mask as shown in Figure 4, the individual rectangular pattern has a rounded elliptical light distribution. It is obvious that the light distribution represented by 121 and 111 in Figure 4 is substantially elliptical, in contrast with the substantially rectangular distribution represented by 120 and 110 in Figure 3. Moreover in the known example of Figure 4, the light distribution of the mutually adjacent patterns are proximate to each other, particularly in the portions 100 thereof, and the patterns obtained actually by exposure and development become coarser than the original light distributions, whereby the patterns are extended consequently to cause a fault that the portions, which are not to be connected, are connected. To prevent such faults, it is necessary further to increase the tolerance, so that eventually the known mask cannot be used for forming extremely fine patterns. Meanwhile in the case of Figure 3, the portions 100 are sufficiently spaced apart from each other, so that adequate patterns can be formed without any problem. The light distributions are substantially parallel and satisfactory in the mutually proximate portions of the patterns 120 and 110 in Figure 3, whereas the distributions in the patterns 121 and 111 in Figure 4 are not mutually parallel, and are so constricted inward of rectangles as to be in the shape of gourds.

Thus, it is rendered possible, by means of such a phase shifting mask, to realize finer patterns than the known ones. Furthermore, when using the same light source and the same stepper (reduced-size exposure projector), the patterns can be made more minute than those obtained by the known mask, hence achieving the structure of Figure 5A in a satisfactory state.

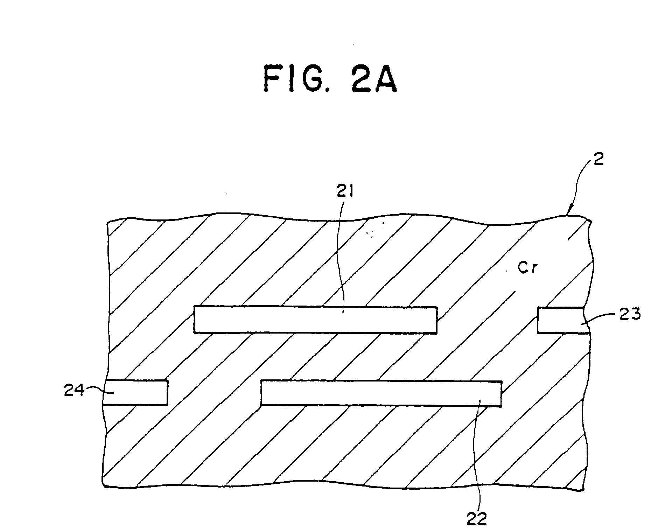

The mask shown in Figure 2A is an example for forming a layer, which is to be in contact with the aforementioned pattern layer, to form gate electrodes 37 and 38 in Figure 5A. In this example, the gate electrodes 37 and 38 can be formed of light transmitting segments 21 and 22 without employing a mask according to the present invention. Since the two light transmitting segments are disposed to be mutually parallel, it is a matter of course that, if they are sufficiently proximate to each other, this example is shapable as a phase shifting mask by adopting a mask according to the present invention. In Figure 2A, there are also shown light transmitting portions 23 and 24 for forming gate electrodes in adjacent cells.

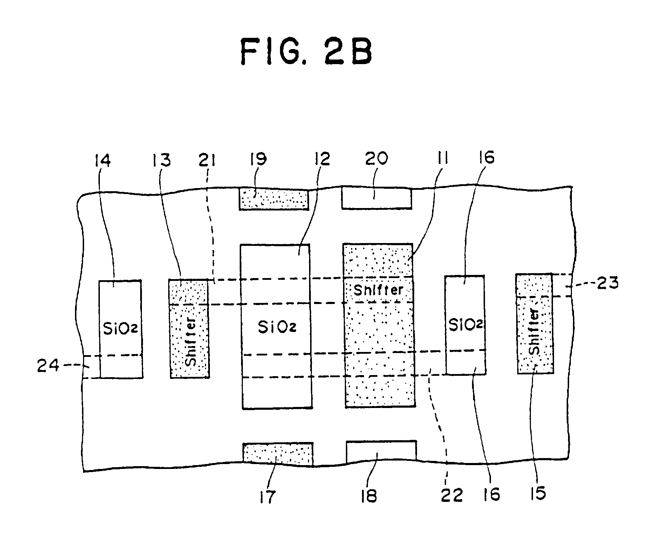

Figure 2B illustrates a structure obtained by superposing the masks of Figures 1 and 2A on each other, wherein gate-forming mask patterns 21 to 24 are represented by broken lines. The structures of Figure 2B substantially corresponds to the entirety of Figure 5A.

In this embodiment where exposure light is emitted from a KrF excimer laser, an excellent result is attainable with the minimum line width diminished to 0.3 μm.

In the case of employing G rays (wavelength 0.45 μm) or the like, the space between parallel proximate portions is set to 0.5 μm or so.

It is preferred that the space between the mutually proximate parallel segments be substantially equal to the wavelength of the exposure light employed.

Denoted by reference numeral 4 in Figure 5A is silicon dioxide serving for isolation of elements.

In this embodiment, as described above, an improvement is achieved in the complicated elemental patterns of a CMOS memory by adopting the phase shifting method, so that extremely fine patterns can be formed. This permits dimensional reduction of cells as well.

Second Embodiment

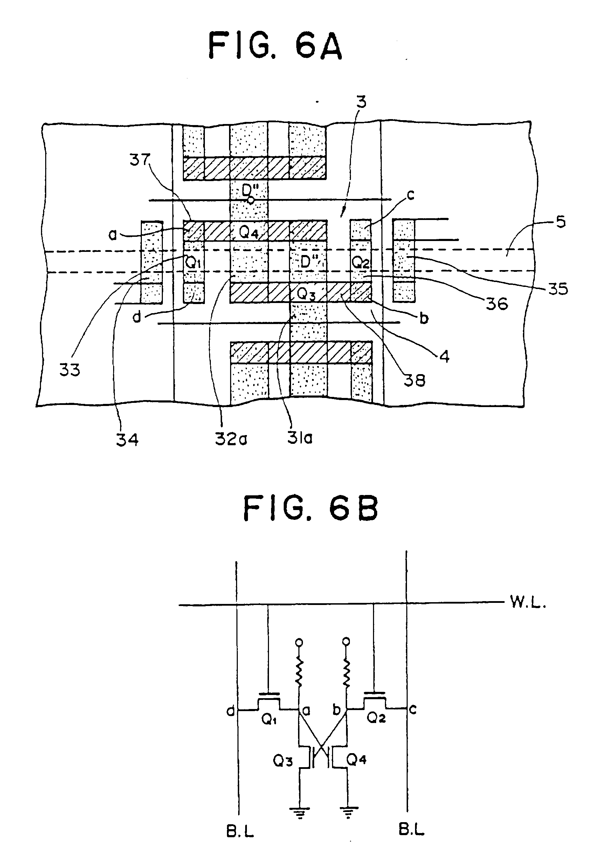

Figures 6A and 6B show another exemplary semiconductor memory structure, wherein Figure 6A illustrates its form, and Figure 6B is a circuit diagram corresponding thereto. This embodiment is a modification of the structure shown in Figure 5A, wherein the diffused layers D and D′ of adjacent cells (Figure 5A) are connected together to be common as represented by D″, so that the vertical dimension of each cell is diminished. As compared with one cell unit of Figure 5A having a vertical length of 3.8 μm and a horizontal length of 2.4 μm, the corresponding dimensions in this embodiment can be reduced to 3.5 μm and 2.1 μm respectively.

Figure 6 shows a word line (W.L.), and the same reference numerals and symbols as those used in Figure 5 denotes the same or corresponding components.

In this second embodiment also, the semiconductor memory device can be produced effectively by using a phase shifting mask according to the present invention with corresponding patterns.

**Claims**

1. A method of producing a semiconductor device using a phase shifting mask, the mask comprising a light shielding region (10), light transmitting portions (12, 14, 16, 18, 20) and phase shifting film portions (11, 13. 15, 17, 19) on a substrate (1) transparent to the wavelength of coherent exposure light, said light transmitting portions and phase shifting film portions being arranged alternately in pairs (11/12, 13/11, 15/16, 17/18, 19/20), each pair consisting of one light transmitting portion and one phase shifting film portion and including mutually adjacent parallel portions, the spacings of the mutually adjacent parallel portions of said pairs and the thicknesses of said film portions being such as to promote destructive interference of the exposure light, characterised in that:

the semiconductor device is a semiconductor memory structure having a plurality of cells (3) each comprising a four transistor circuit (Q1 to Q4) formed of elemental patterns; said mutually adjacent parallel portions of said pairs (11/12 etc) are arranged such that the mutually adjacent parallel portions of three adjacent pairs (34/33, 32/31, 36/35) of said elemental patterns corresponding thereto are positioned parallel with one another and such that the mutually adjacent parallel portions of the elemental patterns of the central one (32/31) of said three pairs are within one of said cells and the mutually adjacent parallel portions of the elemental patterns of each of the other two (34/33, 36/35) of said three pairs are arranged so that one (33, 36) is within said one cell and the other (34, 35) is in a respective cell adjacent to said one cell; and

the four (33, 32, 31, 36) said mutually adjacent parallel portions of said three adjacent pairs of elemental patterns that are within said one cell are interconnected to form said four transistor circuit (Q1 to Q4).

2. A method according to claim 1, wherein said elemental patterns are formed as elemental patterns of a first pattern layer and another pattern layer comprising further elemental patterns (37,38) is formed, said further elemental patterns (37, 38) effecting said interconnection of the four (33, 32, 31, 36) mutually adjacent parallel portions of said three adjacent pairs of elemental patterns that are within said one cell to form said four transistor circuit (Q1 to Q4).

3. A method according to claim 1 or claim 2, wherein said elemental patterns of said first pattern layer are formed as diffused layer patterns.

4. A method according to claim 1, claim 2 or claim 3. wherein said semiconductor device is formed as a CMOS device.

**Patentansprüche**

1. Verfahren zur Herstellung einer Halbleitereinrichtung unter Verwendung einer phasenverschiebenden Maske, wobei die Maske einen Lichtabschirmbereich (10), Lichtdurchlaßabschnitte (12, 14, 16, 18, 20) und phasenverschiebende Filmabschnitte (11, 13, 15, 17, 19) auf einem für die Wellenlänge kohärenten Belichtungslichts transparenten Substrat (1) aufweist, wobei die Lichtdurchlaßabschnitte und die phasenverschiebenden Filmabschnitte alternierend in Paaren (11/12, 13/14, 15/16, 17/18, 19/20) angeordnet sind, wobei jedes Paar aus einem Lichtdurchlaßabschnitt und einem phasenverschiebenden Filmabschnitt besteht und gegenseitig benachbarte parallele Abschnitte aufweist, wobei die Abstände der gegenseitig benachbarten parallelen Abschnitte der Paare und die Dicken der Filmabschnitte derart sind, daß einer destruktiven Interferenz des Belichtungslichts Vorschub geleistet wird, dadurch gekennzeichnet, daß

die Halbleitereinrichtung eine Halbleiterspeicherstruktur mit mehreren Zellen (3) ist, deren jede eine aus elementaren Mustern gebildete Viertransistorschaltung (Q1 bis Q4) aufweist, die gegenseitig benachbarten parallelen Abschnitte der Paare (11/12 usw.) so angeordnet sind, daß die gegenseitig benachbarten parallelen Abschnitte der drei benachbarten Paare (34/33, 32/31, 36/35) der damit korrespondierenden elementaren Muster parallel zueinander und so angeordnet sind, daß die gegenseitig benachbarten parallelen Abschnitte der elementaren Muster des zentralen (32/21) der drei Paare sich in einer der Zellen befinden, und die gegenseitig benachbarten parallelen Abschnitte der elementaren Muster jedes übrigen (34/33, 36/35) der drei Paare so angeordnet sind, daß sich einer (33, 36) in der einen Zelle und der andere (34/35) in je einer der einen Zelle benachbarten Zelle befindet, und die sich in der einen Zelle befindenden vier (33, 32, 31, 36) der gegenseitig benachbarten parallelen Abschnitte der drei benachbarten Paare elementarer Muster zur Bildung der Viertransistorschaltung (Q1 bis Q4) miteinander verbunden sind.

2. Verfahren nach Anspruch 1, wobei die elementaren Muster als elementare Muster einer ersten Musterschicht ausgebildet sind und eine weitere elementare Muster (37, 38) aufweisende andere Musterschicht ausgebildet ist, wobei die weiteren elementaren Muster (37, 38) die Verbindung der sich in der einen Zelle befindenden vier gegenseitig benachbarten parallelen Abschnitte (33, 32, 31, 36) der drei benachbarten Paare elementarer Muster miteinander zur Bildung der Viertransistorschaltung (Q1 bis Q4) bewirken.

3. Verfahren nach Anspruch 1 oder 2, wobei die elementaren Muster der ersten Musterschicht als diffundierte Schichtmuster ausgebildet sind.

4. Verfahren nach Anspruch 1, Anspruch 2 oder Anspruch 3, wobei die Halbleitereinrichtung als eine CMOS-Einrichtung ausgebildet ist.

**Revendications**

1. Procédé de fabrication d'un dispositif a semiconducteur utilisant un masque à déphasage, le masque comprenant une région faisant écran à la lumière (10), des parties transmettant la lumière (12, 14, 16, 18, 20) et des parties en film déphaseur (11, 13, 15, 17, 19) sur un substrat (1) transparent à la longueur d'onde de la lumière cohérente d'exposition, lesdites parties transmettant la lumière et parties en film déphaseur étant disposées de manière alternée par paires (11/12, 13/14, 15/16, 17/18, 19/20), chaque paire étant composée d'une partie transmettant la lumière et d'une partie en film déphaseur et comportant des parties parallèles mutuellement voisines, et les espacements des parties parallèles mutuellement voisines desdites paires et l'épaisseur desdites parties en film étant tels qu'ils favorisent l'interférence destructive de la lumière d'exposition, caractérisé en ce que: - le dispositif à semiconducteur est une structure de mémoire à semiconducteur ayant une pluralité de cellules (3) comprenant chacune un circuit à quatre transistors (Q1 à Q4) formée de motifs élémentaires,

lesdites parties parallèles mutuellement voisines desdites paires (11/12, etc.) étant disposées de telle manière que les parties parallèles mutuellement voisines de trois paires voisines (34/33, 32/31, 36/35) desdits motifs élémentaires correspondant à celles-ci soient disposées pour être parallèles entre elles et de telle manière que les parties parallèeles mutuellement voisines des motifs élémentaires de la paire centrale (32/31) desdites trois paires soient à l'intérieur d'une desdites cellules et que les parties parallèles mutuellement voisines des motifs élémentaires de chacune des deux autres paires (34/33, 36/35) desdites trois paires soient disposées de telle manière qu'une paire (33, 36) soit à l'intérieur de ladite une cellule et l'autre paire (34, 35) soit dans une cellule respective voisine de ladite une cellule; et les quatre parties (33, 32, 31, 36) desdites parties parallèles mutuellement voisines desdits trois paires voisines de motifs élémentaires qui sont à l'intérieur de ladite une cellule sont interconnectées pour former ledit circuit à quatre transistors (Q1 à Q4).

2. Procédé selon la revendication 1, dans lequel lesdits motifs élémentaires sont formés sous la forme de motifs d'une première couche à motifs, et une autre couche à motifs comprenant d'autres motifs élémentaires (37, 38) est formée, lesdits autres motifs élémentaires (37, 38) réalisant ladite interconnexion des quatre (33, 32, 31, 36) parties parallèles mutuellement voisines desdites trois paires voisines de motifs élémentaires qui sont à l'intérieur de ladite une cellule pour former ledit circuit a quatre transistors (Q1 à Q4).

3. Procédé selon la revendication 1 ou la revendication 2, dans lequel lesdits motifs élémentaires de ladite première couche à motifs sont formés sous la forme de motifs diffusés.

4. Procédé selon la revendication 1, la revendication 2 ou la revendication 3, dans lequel ledit dispositif à semiconducteur est formé sous la forme d'un dispositif CMOS.

# FIG. 1

# FIG. 2A

# FIG. 2B

# FIG. 3

# FIG. 4

# FIG. 5A

# FIG. 5B

# FIG. 6A

# FIG. 6B

# FIG. 7

## FIG. 8A

## FIG. 8B

0.000 0.500    1.500    2.421

0.000 0.500    1.500    2.421

EP 0 432 900 B1

# FIG. 9A

## FIG. 9B

Light phase in mask

Light phase in exposed menber

Light intensity in exposed member

EP 0 432 900 B1